# EUROPEAN PATENT SPECIFICATION

(11) **EP 2 834 559 B1**
(45) Date of publication and mention of the grant of the patent: **30.03.2016**
(21) Application number: 13728516.9
(22) Date of filing: 04.04.2013
(51) Int. Cl.: F21V 29/00

(54) **LED LIGHT STRUCTURE**
BELEUCHTUNGSSTRUKTUR MIT LEUCHDIODEN
STRUCTURE D'UN LUMINAIRE A DIODES ÉLECTROLUMINESCENTES

(30) Priority: 05.04.2012 US 201261620502 P
(43) Date of publication of application: 11.02.2015
(73) Proprietor: Koninklijke Philips N.V., 5656 AE Eindhoven (NL)
(72) Inventor: VERBRUGH, Stefan Marcus, NL-5656 AE Eindhoven (NL); KURT, Ralph, NL-5656 AE Eindhoven (NL); DUMOULIN, Raimond Louis, NL-5656 AE Eindhoven (NL)
(74) Representative: van Eeuwijk, Alexander Henricus Waltherus
(86) International application number: PCT/IB2013/052704
(87) International publication number: WO 2013/150481

(56) References cited:
- EP-A2- 2 295 844
- WO-A2-2007/107601
- DE-U1-202007 008 258
- DE-U1-202007 008 258
- US-A1- 2007 230 184
- US-A1- 2010 214 777
- US-A1- 2011 180 817

## Description

### FIELD OF THE INVENTION

The present invention relates to an LED light structure.

### BACKGROUND OF THE INVENTION

The most important value driver for multicolor LED spot modules is the output per mm² which is very much determined by heat management. In order to achieve a high light output per mm², the heat transfer from the LEDs to the environment must be excellent. In addition, the fraction of active LED area must be as large as possible (LEDs closely packaged). Good heat transfer and high LED density are thus important value drivers for LED spots.

Systems exist in which LED chips are mounted on a substrate (in general a ceramic substrate) and this substrate is mounted on a PCB (in most cases a Metal Core PCB) and this PCB is mounted on a heat sink. Mounting LED chips directly on a PCB is not preferred because of the high mismatch of the thermal expansion coefficients of Copper and the LED chip.

A disadvantage with mounting one or more PCBs on a heat sink is that the interface between the PCB and the heat sink is a thermal barrier which could cause a temperature increase of the LEDs of ~10°C which is a significant increase.

Soldering the PCB with all the LEDs on a heat sink considerably reduces the temperature gap, but has other disadvantages: Soldering the complete PCB on the heat sink is a difficult and costly process (must heat the complete heat sink which takes a long time and thus a long production time (increased cost). Furthermore, LEDs are on a high temperature during soldering which might cause deterioration of the LEDs. Additionally, quality problems in the solder joint can occur such as, e.g., voids which lead to a high thermal resistance, or early failures due to thermal expansion mismatch, etc.

A disadvantage with soldering many LEDs directly on a heat sink with a high packing density is that if one LED is damaged or a soldering fails, the complete LED array is wasted which is expensive.

Soldering LEDs directly on copper results in poor reliability and lifetime of the solder joint because of the thermal expansion mismatch of the copper and the LEDs. LEDs chips glued directly on copper have low thermal conductivity due to the glue.

US2010/0214777A1 discloses a light-emitting device having a light-emitting portion comprising a substrate having a mounting surface for mounting a LED element and a metal portion formed on a surface of the substrate opposite to the mounting surface, the substrate comprising ceramic or a semiconductor and the metal portion being bondable to a solder material and a heat dissipating member having, on a surface thereof, a junction treated so as to be bondable to the solder material and a heat dissipating film formed in a periphery of the junction, wherein the metal portion of the light emitting portion is bonded to the junction of the heat dissipating member by the solder material.

EP2295844A2 discloses a light-emitting device including a ceramic substrate, a plurality of light-emitting elements, and pressure member. The substrate includes a first surface in contact with a thermally radiative member, a second surface positioned in a side opposite to the first surface, and an outer circumferential surface which bridges outer circumferential edges of the first surface and the second surface. The light-emitting elements are mounted on the second surface of the substrate.

US2011/0180817A1 discloses a light emitting device including a ceramic substrate, a plurality of LED chips, a printed resistor connected in parallel with the plurality of LED chips, a dam resin made of a resin having a low optical transmittance, a fluorescent-material containing resin layer, and an anode-side electrode and a cathode-side electrode, which are provided on a primary surface of the ceramic substrate so as to face each other along a first direction on the primary surface and which are disposed below at least one of the dam resin and the fluorescent-material-containing resin layer.

### SUMMARY OF THE INVENTION

It is an object of the present invention to overcome or alleviate problems of the prior art.

According to an aspect o the invention there is provided a light structure comprising a heat sink, a plurality of ceramic tiles, and at least one LED arranged on each ceramic tile, wherein the ceramic tiles are mounted in direct contact with the heat sink without any intermediate thermal barrier.

According to the invention, there is only a ceramic tile between the LED dies and the heat sink. In particular, there is no PCB or similar layer with high thermal resistance. The heat resistance from the LEDs to the heat sink (or more precisely from the LEDs to the ambient air) is thereby extremely low. At the same time, several LEDs can be mounted on each ceramic tile, which can be tested before mounting. In case a LED or bond wire is damaged, only that tile is wasted.

According to a preferred embodiment, the ceramic tiles are soldered to the heat sink. This is possibly for example if the heat sink is of metal (e.g. copper) and the ceramic tiles are made of AlN (aluminum nitride).

According to the invention, a PCB is attached to the heat sink next to the plurality of ceramic tiles, and be electrically connected to the LEDs, e.g. via bond wires. Such a PCB may carry various circuitry, such as driver circuitry and control circuitry. The PCB is not intended to carry any LEDs, and the thermal connection with the heat sink is therefore not an issue.

The ceramic tiles are preferably of a sufficiently small size such that problems with thermal expansion are avoided. As an example, a length of the plurality of tiles may be in the range of 4 to 6 mm.

The light structure may further comprise at least one PCB-mounted LED mounted on the heat sink. This arrangement is advantageous when having a combination of LEDs having bottom contacts and LEDs having one bottom and one top contact in the same array. Having different LEDs close to each other in the same array, especially alternating rows of LEDs of one type with rows of LEDs of another type is advantageous if the different types of LEDs emit light in different colors. This alternating of colors is advantageous for mixing the colors in the optics. The term "alternating" is here in no way limited to only two types of LEDs, but also applies to other predefined sequences of LEDs.

The ceramic tiles and the PCB-mounted LEDs are preferably mounted on the heat sink in such a way that the light emitting surfaces of LEDs on the ceramic tiles and the light emitting surfaces of the PCB-mounted LEDs are on the same level with each other. This is advantageous in that light from one LED is not blocked by its neighbor.

The heat sink may comprise a plurality of separate heat sink elements, each element having a plurality of ceramic tiles mounted thereon, with electrical connectors connecting LEDs on different ceramic tiles with each other. An advantage with this is that one element can be removed and exchanged for a new one or repaired. Repair can be advantageous to increase the yield during manufacturing and when failures occur during use.

The light structure may comprise cooling channels oriented transversely with respect to contact planes between the aid heat sink elements, and passing through openings in said heat sink elements.

Cooling may be provided by cooling fins or cooling pipes and may be based on a flow of cooling air or cooling liquid. Having a cooling liquid is advantageous in that it is possible to arrange the heat exchanger at a distance from the light structure and it is possible to keep the light structure small since the cooling pipes for cooling liquid do not necessarily take up extra space. This increases the design freedom considerably.

The cooling channels may extend lengthwise through the plurality of parts of the heat sink. This is advantageous in that even more cooling of the light structure is provided.

The plurality of tiles may be arranged in a first plurality of rows, a plurality of second PCBs may be arranged in a second plurality of rows and the rows of the first plurality of rows and the rows of the second plurality of rows may extend along each other and are arranged in an alternate way, that is, the rows of the first plurality of rows and the rows of the second plurality of rows are arranged every other way.

The light structure may be manufactured by soldering the plurality of tiles to the heat sink using a soldering material selected from the group of SAC, SAC+ or PAS. This is advantageous since the soldering material can accommodate the thermal expansion mismatch between the tiles and the heat sink.

Any PCB may be mounted on the heat sink by soldering or pressing the PCB on the heat sink. Pressing is necessary for a low thermal resistance. Soldering provides an even lower thermal resistance. The advantages of pressing are that it is easier in manufacturing and that it is more reliable.

Also PCB-mounted LEDs maybe soldered to the heat sink using a soldering material selected from the group of SAC, SAC+ or PAS. This is advantageous since the soldering material can accommodate the thermal expansion mismatch between the tiles and the PCB.

After soldering, a thickness of the soldered material may be in the range of 10 to 150 µm. This is advantageous in that the soldering material can accommodate some thermal expansion mismatch and is thin enough to have a low thermal resistance.

It is noted that the invention relates to all possible combinations of features recited in the claims.

### BRIEF DESCRIPTION OF THE DRAWINGS

This and other aspects of the present invention will now be described in more detail, with reference to the appended drawings showing embodiments of the invention in which,
Fig. 1 is a schematic side view of an embodiment of the inventive light structure.
Fig. 2 is a schematic perspective view of an embodiment of the inventive light structure.
Fig. 3 is a schematic side view of an embodiment of the inventive light structure.
Fig. 4a is a schematic perspective view of an embodiment of the inventive light structure.
Fig. 4b is a schematic perspective view of the embodiment of the inventive light structure of Fig. 4a.

### DETAILED DESCRIPTION

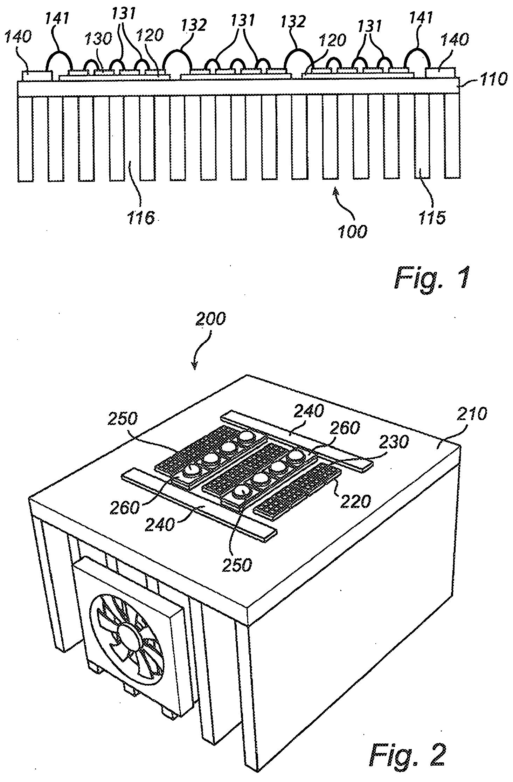

Fig. 1 is a schematic side view of an embodiment of the inventive light structure. The light structure 100 comprises a heat sink 110. The heat sink 110 is arranged to cool the light structure 100 by dissipating heat into the surrounding air. This is accomplished through increasing the surface area in contact with the cooling fluid surrounding it, such as the air. The heat sink 110 can, e.g., be a heat exchanger such as those used in refrigeration and air conditioning systems or a radiator such as those used in cars. In one embodiment, the heat sink has cooling fins 115, as is disclosed in Fig. 1. The cooling fins 115 comprise cooling air 116. The heat sink 110 can, e.g., be made of copper.

The light structure 100 further comprises a plurality of ceramic tiles 120. The ceramic tiles 120 can, e.g., be made of AlN (aluminum nitride). AlN has about the same thermal expansion coefficient as the LEDs. The inventors have found through testing that the thermal expansion mismatch between the AlN tiles and the copper heat sink does not lead to problems. The ceramic tiles 120 can have lengths in the range of 2 to 20 mm, preferably between 3 and 8 mm, most preferred between 4 to 6 mm. In one embodiment, the size of the ceramic tiles is 5x5 mm. The ceramic tiles 120 can be quadratic. The ceramic tiles can have a thickness of 250 µm.

A plurality of LEDs 130 are arranged on each ceramic tile 120. A first set of electrical connectors connect LEDs mounted on the same ceramic tile. These connectors 131 are here illustrated as bond wires, but may also be conducting tracks on the surface of the ceramic tile. A second set of electrical connectors connect LEDs on different ceramic tiles with each other. These connectors 132 are here illustrated as bond wires. The plurality of ceramic tiles 120 are in direct contact with the heat sink 110.

Two PCBs 140 are attached to the heat sink 110 next to the plurality of ceramic tiles 120. The PCBs 140 are electrically connected to the LEDs 130, here via wires 141. The PCBs 140 can have multiple layers in order to facilitate connecting electrical connections and components other than LEDs to the PCBs 140. The PCBs 140 can be made of a material that is cheaper and simpler than the ceramic tiles 120. E.g., the PCBs can be made of an FR4 with Copper tracks. The PCBs 140 contain means to connect to the light structure 100, e.g. using wires, to a driving device. Preferably, these PCBs 140 have multiple layers in order to obtain a reduced size.

Fig. 2 is a schematic perspective view of an embodiment of the inventive light structure. The light structure 200 corresponds to the light structure 100 of Fig. 1 but with a couple of additions. The light structure 200 comprises a heat sink 210 which corresponds to the heat sink 110. The light structure 200 further comprises a plurality of ceramic tiles 220 and on each ceramic tile 220 are a plurality of LEDs 230 arranged. The ceramic tiles 220 correspond to the ceramic tiles 120 of Fig. 1. Furthermore, the plurality of LEDs 230 correspond to the plurality of LEDs 130 of Fig. 1. Two PCBs 240 are attached to the heat sink 210 next to the plurality of ceramic tiles 220. The PCBs 240 are connected to the LEDs 230 via wires (not shown). The PCBs 240 correspond to the PCBs 140 of Fig. 1.

The light structure 200 here further comprises a plurality of LEDs 250 having bottom contacts which are mounted on PCBs 260 (referred to as PCB-mounted LEDs). These LEDs 250 can, e.g., be of the type Rebel or Cree XPG. The PCBs 260 are mounted on the heat sink 210 next to the plurality of ceramic tiles 220 and the LEDs 230.

In multicolor systems, several types of LEDs are used (e.g. several colors, with and without phosphor, from different LED manufacturers, etc). This means that some of the LED types might have bottom contacts and can hence not be arranged on ceramic tiles as can LEDs 130 and 230. Instead, these LEDs are arranged as the LEDs 250. Therefore, the embodiment of Fig. 2 is advantageous in multicolor systems, e.g., for entertainment.

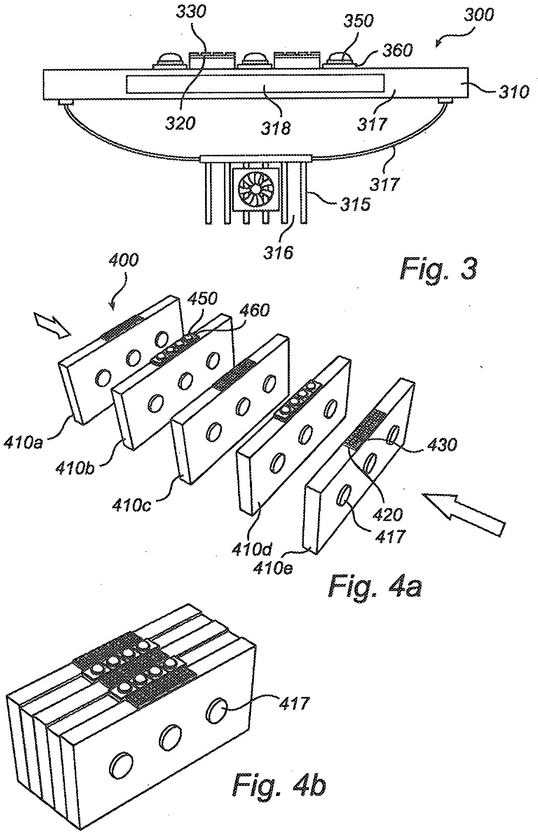

Fig. 3 is a schematic side view of an embodiment of the inventive light structure. The light structure 300 corresponds to the light structure 200 in Fig. 2. The light structure comprises ceramic tiles 320, LEDs 330, PCBs 360 and LEDs 350 having bottom contacts. As can be seen from Fig. 3, the ceramic tiles 320 are arranged at different levels than the PCB-mounted LEDs 350 so that the upper, light emitting surfaces of the LEDs 330 and LEDs 350 are on the same level, or on equal heights. This is here accomplished by arranging the ceramic tiles 320 on protrusions of the heat sink 310.

The heat sink 310 also comprises cooling fins 315 dissipating heat to surrounding cooling air 316. Additionally, the heat sink 310 comprises cooling pipes 317 carrying a cooling liquid 318. This heat sink 310 can thus be cooled using a liquid, e.g., water. As is visible in Fig. 3, the heat exchanger can be arranged at a distance from the LEDs.

Fig. 4a is a schematic perspective view of an embodiment of the inventive light structure. The heat sink 410 of the light structure 400 in Fig. 4a is divided into a plurality of elements 410a, b, c, d, and e. On elements 410a, c, and e, a plurality of ceramic tiles 420 are arranged, each carrying a plurality of LEDs 430. On each part 410b and d a plurality of PCB-mounted LEDs 450 are arranged. The parts 410a, b, c, d, and e are merged together, therewith defining contact planes in between them, as is shown in Fig. 4b. The light structure 400 has cooling pipes 417 which are oriented transversely with respect to the contact planes. The cooling pipes 417 can carry a cooling liquid and/or cooling fluid. It is also possible (not shown) to let cooling fins or cooling pipes extend parallel to the contact planes. In Fig. 4a and b, heat sink elements with ceramic tiles and heat sink elements with PCB-mounted LEDs are arranged in an alternating manner.

Next, a method for manufacturing the light structure 100, 200, 300, 400 outlined above will be described.

The plurality of tiles are soldered to the heat sink using a soldering material selected from the group of SAC, SAC+ or PAS. The soldering material can compensate for the thermal expansion mismatch between the heat sink and the ceramic tile. The PCBs are attached to the heat sink by pressing the PCB on the heat sink. The LEDs having bottom contacts are soldered to the second PCB using a soldering material selected from the group of SAC, SAC+ or PAS. A thickness of the soldered material, after soldering, is in the range of 10 and 200 µm, preferably 30 to 150 µm.

In summary, the disclosed embodiments relate to a light structure 100, 200, 300, 400 comprising a heat sink 110, 210, 310, 410, a plurality of ceramic tiles 120, 220, 320, 420, at least one LED 130, 230, 330, 430 arranged on each ceramic tile 120, 220, 320,420, a plurality of wires connecting the LEDs 130, 230, 330, 430, the plurality of ceramic tiles 120, 220, 320, 420 being in direct contact with the heat sink 110, 210, 310, 410.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. Any reference signs in the claims should not be construed as limiting the scope.

## Claims

1. A light structure (100, 200, 300, 400) comprising:
a heat sink (110, 210, 310, 410),
a plurality of ceramic tiles (120, 220, 320, 420),
at least one LED (130, 230, 330,430) arranged on each ceramic tile (120, 220, 320, 420), wherein the ceramic tiles (120, 220, 320, 420) are mounted in direct contact with the heat sink (110, 210, 310, 410) without any intermediate thermal barrier, and wherein the light structure further comprises at least one PCB-mounted LED (250, 350, 450) mounted on the heat sink (210, 310, 410) and a PCB (140, 240, 340, 440) attached to the heat sink (110, 210, 310, 410), electrically connected to at least one of the LEDs (130, 230, 330,430) and not carrying any LED and wherein the PCB (140, 240, 340, 440) is of a material different from the ceramic tiles.

2. The light structure according to claim 1, further comprising a first set of electrical connectors connecting LEDs on a same ceramic tile, and a second set of electrical connectors connecting LEDs on different ceramic tiles.

3. The light structure (100, 200, 300, 400) according to claim 1, wherein the PCB (140, 240, 340, 440) not carrying any LED carries driver circuitry and/or driver circuitry.

4. The light structure (100, 200, 300, 400) according to anyone of claims 1-3, wherein a length of each tile (120, 220, 320, 420) is in the range of 4 to 6 mm.

5. The light structure according to any one of the preceding claims, wherein the ceramic tiles (120, 220, 320,420) are made of AlN.

6. The light structure according to any one of the preceding claims, wherein the heat sink is made of metal.

7. The light structure according to any one of the preceding claims, wherein said ceramic tiles have been soldered to said heat sink.

8. The light structure according to claim 7, wherein the ceramic tiles have been soldered using a soldering material selected from the group of SAC, SAC+ and PAS.

9. The light structure according to claim 7 or 8, wherein a thickness of the soldering material is in the range of 10 to 150 µm

10. The light structure (200, 300, 400) according to claim 1, wherein the ceramic tiles and the PCB-mounted LEDs are mounted on the heat sink, in such a way that the light emitting surfaces of LEDs on the ceramic tiles and the light emitting surfaces of the PCB-mounted LEDs are on the same level with each other.

11. The light structure (400) according to anyone of the preceding claims, wherein the heat sink (410) comprises a plurality of separate heat sink elements (410 a- e) each element having a plurality of ceramic tiles mounted thereon, with electrical connectors connecting LEDs on different ceramic tiles with each other.

12. The light structure according to claim 11, further comprising additional heat sink elements having a plurality of PCB-mounted LEDs mounted thereon, with electrical connectors connecting the PCB-mounted LEDs with each other.

13. The light structure according to claim 11 or 12, further comprising cooling channels oriented transversely with respect to contact planes between said heat sink elements, and passing through openings in said heat sink elements.

14. The light structure (200, 300, 400) according to anyone of the preceding claims, wherein the plurality of ceramic tiles (220, 320, 420) are arranged in a first plurality of rows, wherein a plurality of PCB-mounted LEDs (260, 360, 460) are arranged in a second plurality of rows and wherein rows of tiles and rows of PCB-mounted LEDs extend along each other and are arranged in an alternate way.

## Patentansprüche

1. Lichtstruktur (100, 200, 300, 400), folgendes umfassend:
einen Kühlkörper (110, 210, 310, 410),
eine Vielzahl von Keramikkacheln (120, 220, 320, 420),
zumindest eine LED (130, 230, 330, 430), die auf jeder Keramikkachel (120, 220, 320, 420) angeordnet ist, wobei die Keramikkacheln (120, 220, 320, 420) ohne unmittelbare thermische Barriere in direktem Kontakt mit dem Kühlkörper (110, 210, 310, 410) montiert sind, und wobei die Lichtstruktur darüber hinaus zumindest eine auf einer Leiterplatte montierte LED (250, 350, 450) umfasst, die auf dem Kühlkörper (110, 210, 310, 410) montiert ist und eine Leiterplatte (140, 240, 340, 440), die auf dem Kühlkörper (110, 210, 310, 410) befestigt ist, die elektrisch mit zumindest einer der LEDs (130, 230, 330, 430) verbunden ist, und keine LED trägt, und wobei die Leiterplatte (140, 240, 340, 440) aus einem Werkstoff besteht, der sich den von den Keramikkacheln unterscheidet.

2. Lichtstruktur nach Anspruch 1, die darüber hinaus einen ersten Satz an elektrischen Steckern umfasst, die LEDs auf einer selben Keramikkachel anschließen, und einen zweiten Satz an elektrischen Steckern, die LEDs auf verschiedenen Keramikkacheln anschließen.

3. Lichtstruktur (100, 200, 300, 400) nach Anspruch 1, wobei die Leiterplatte (140, 240, 340, 440), die keine LED trägt, Treiberschaltung und/ oder Treiberschaltung trägt.

4. Lichtstruktur (100, 200, 300, 400) nach irgendeinem der Ansprüche 1 bis 3, wobei die Länge einer jeden Kachel (120, 220, 320, 420) in der Größenordnung von 4 bis 6 mm liegt.

5. Lichtstruktur nach irgendeinem der vorherigen Ansprüche, wobei die Keramikkacheln (120, 220, 320, 420) aus AlN gefertigt sind.

6. Lichtstruktur nach irgendeinem der vorherigen Ansprüche, wobei der Kühlkörper aus Metall gefertigt ist.

7. Lichtstruktur nach irgendeinem der vorherigen Ansprüche, wobei die besagten Keramikkacheln auf den besagten Kühlkörper gelötet worden sind.

8. Lichtstruktur nach Anspruch 7, wobei die Keramikkacheln unter Verwendung eines Lötmaterials gelötet worden sind, der aus einer Gruppe von SAC, SAC+ und PAS ausgewählt wird.

9. Lichtstruktur nach Anspruch 7 oder 8, wobei eine Dicke des Lötmaterials in einer Größenordnung von 10 bis 150 µm liegt.

10. Lichtstruktur (200, 300, 400) nach Anspruch 1, wobei die Keramikkacheln und die auf einer Leiterplatte montierten LEDs derart auf den Kühlkörper montiert sind, sodass sich die lichtemittierenden Oberflächen von LEDs auf den Keramikkacheln und die lichtemittierenden Oberflächen der auf einer Leiterplatte montierten LEDs auf einer selben Ebene zueinander befinden.

11. Lichtstruktur (400) nach irgendeinem der vorherigen Ansprüche, wobei der Kühlkörper (410) eine Vielzahl von getrennten Kühlkörperelementen (410 a-e) umfasst, wobei jedes Element eine Vielzahl von Keramikkacheln aufweist, die darauf montiert sind, mit elektrischen Steckern, die LEDs auf verschiedenen Keramikkacheln miteinander verbinden.

12. Lichtstruktur nach Anspruch 11, die darüber hinaus zusätzliche Kühlkörperelemente umfasst, die eine Vielzahl von auf einer Leiterplatte montierten LEDs aufweisen, die darauf montiert sind, mit elektrischen Steckern, die die auf einer Leiterplatte montierten LEDs miteinander verbinden.

13. Lichtstruktur nach Anspruch 11 oder 12, die darüber hinaus Kühlkanäle umfasst, die im Verhältnis zu den Kontaktflächen zwischen den besagten Kühlkörperelementen quer ausgerichtet sind, und durch die Öffnungen in den besagten Kühlkörperelementen verlaufen.

14. Lichtstruktur (200, 300, 400) nach irgendeinem der vorherigen Ansprüche, wobei die Vielzahl von Keramikkacheln (220, 320, 420) in einer ersten Vielzahl von Reihen angeordnet sind, wobei eine Vielzahl von auf einer Leiterplatte montierten LEDs (260, 360, 460) in einer zweiten Vielzahl von Reihen angeordnet sind, und wobei sich Reihen von Kacheln und Reihen von auf einer Leiterplatte montierten LEDs nebeneinander erstrecken und abwechselnd angeordnet sind.

## Revendications

1. Structure d'éclairage (100, 200, 300, 400) comprenant :
un dissipateur thermique (110, 210, 310, 410),
une pluralité de carreaux de céramique (120, 220, 320, 420),
au moins une LED (130, 230, 330, 430) agencée sur chaque carreau de céramique (120, 220, 320, 420), dans laquelle les carreaux de céramique (120, 220, 320, 420) sont montés en contact direct avec le dissipateur thermique (110, 210, 310, 410) sans aucune barrière thermique intermédiaire, et dans laquelle la structure d'éclairage comprend en outre au moins une LED montée sur carte de circuit imprimé, PCB, (250, 350, 450) montée sur le dissipateur thermique (110, 210, 310, 410), et une PCB (140, 240, 340, 440) attachée au dissipateur thermique (110, 210, 310, 410), reliée électriquement à au moins l'une des LED (130, 230, 330, 430) et ne portant pas de LED et dans laquelle la PCB (140, 240, 340, 440) est d'un matériau différent des carreaux de céramique.

2. Structure d'éclairage selon la revendication 1, comprenant en outre un premier ensemble de connecteurs électriques connectant des LED sur un même carreau de céramique, et un deuxième ensemble de connecteurs électriques connectant des LED sur différents carreaux de céramique.

3. Structure d'éclairage (100, 200, 300, 400) selon la revendication 1, dans laquelle la PCB (140, 240, 340, 440) ne portant pas de LED porte une circuiterie d'attaque et/ou une circuiterie d'attaque.

4. Structure d'éclairage (100, 200, 300, 400) selon l'une quelconque des revendications 1 à 3, dans laquelle une longueur de chaque carreau (120, 220, 320, 420) est dans la plage de 4 à 6 mm.

5. Structure d'éclairage selon l'une quelconque des revendications précédentes, dans laquelle les carreaux de céramique (120, 220, 320, 420) sont constitués d'AlN.

6. Structure d'éclairage selon l'une quelconque des revendications précédentes, dans laquelle le dissipateur thermique est constitué de métal.

7. Structure d'éclairage selon l'une quelconque des revendications précédentes, dans laquelle lesdits carreaux de céramique ont été soudés sur ledit dissipateur thermique.

8. Structure d'éclairage selon la revendication 7, dans laquelle les carreaux de céramique ont été soudés en utilisant un matériau de soudage sélectionné dans le groupe se composant de SAC, SAC+ et PAS.

9. Structure d'éclairage selon la revendication 7 ou 8, dans laquelle une épaisseur du matériau de soudage est dans la plage de 10 à 150 µm.

10. Structure d'éclairage (200, 300, 400) selon la revendication 1, dans laquelle les carreaux de céramique et les LED montées sur PCB sont montés sur le dissipateur thermique, de telle manière que les surfaces émettrices de lumière des LED sur les carreaux de céramique et les surfaces émettrices de lumière des LED montées sur PCB sont au même niveau.

11. Structure d'éclairage (400) selon l'une quelconque des revendications précédentes, dans laquelle le dissipateur thermique (410) comprend une pluralité d'éléments de dissipateur thermique distincts (410 a-e), chaque élément ayant une pluralité de carreaux de céramique montés sur celui-ci, avec des connecteurs électriques connectant des LED sur différents carreaux de céramique l'une à l'autre.

12. Structure d'éclairage selon la revendication 11, comprenant en outre des éléments de dissipateur thermique supplémentaires ayant une pluralité de LED montées sur PCB montées sur ceux-ci, avec des connecteurs électriques connectant les LED montées sur PCB l'une à l'autre.

13. Structure d'éclairage selon la revendication 11 ou 12, comprenant en outre des canaux de refroidissement orientés transversalement par rapport à des plans de contact entre lesdits éléments de dissipateur thermique et passant à travers des ouvertures dans lesdits éléments de dissipateur thermique.

14. Structure d'éclairage (200, 300, 400) selon l'une quelconque des revendications précédentes, dans laquelle la pluralité de carreaux de céramique (220, 320, 420) sont agencés dans une première pluralité de rangées, dans laquelle une pluralité de LED montées sur PCB (260, 360, 460) sont agencées dans une deuxième pluralité de rangées et dans laquelle des rangées de carreaux et des rangées de LED montées sur PCB s'étendent côte à côte et sont agencées d'une manière en alternance.
